# EUROPEAN PATENT APPLICATION

(11) **EP 2 173 147 A1**
(43) Date of publication of application: **07.04.2010**
(21) Application number: 07790805.1
(22) Date of filing: 13.07.2007
(51) Int. Cl.: H05K 3/46

(54) **WIRING BOARD AND ITS MANUFACTURING METHOD**

(71) Applicant: Ibiden Co., Ltd., Ogaki-shi, Gifu 503-8604 (JP)
(72) Inventor: TAKAHASHI, Michimasa, Ogaki-shi Gifu 503-8503 (JP); AOYAMA, Masakazu, Ogaki-shi Gifu 503-8503 (JP)
(74) Representative: Gendron, Vincent Christian
(86) International application number: PCT/JP2007/064025
(87) International publication number: WO 2009/011025

(57) **Abstract**

A wiring board 19 is structured by laminating first substrate 1, second substrate 2 having a smaller mounting area than that of first substrate 1, and base substrate 3 positioned between first substrate 1 and second substrate 2, where at least a portion of the periphery is made thinner than the central portion. Vias 44 are formed in at least either first substrate 1 or second substrate 2. In base substrate 3, the thickness of the portion bonded only to first substrate 1 is less than that of the portion sandwiched between first substrate 1 and second substrate 2.

## Description

### Technical Field

The present invention relates to a wiring board formed by combining multiple substrates each having a different mounting area, and a method of manufacturing such a wiring board.

### Background Art

Among electronic devices, some are preferred to be made compact and lightweight; cell phones especially are expected to be made thin in addition to being made compact and lightweight. And, wiring boards for use in cell phones are expected to be made compact, lightweight and thin.

However, if a wiring board is made thin, etc., it becomes insufficiently rigid. For example, Patent Literature 1 discloses a technique to address insufficient rigidity in a wiring board. This technique is employed in a wiring board having a reinforced portion, which is formed by making an extended portion of a flexible substrate and folding the extended portion.

In this technique, however, a part of the extended portion is folded over to a conductive pattern thereon which is eventually disconnected. Since this technique uses a flexible substrate, the cost for manufacturing a wiring board is high. A reinforced portion can be provided on the wiring board using a rigid substrate instead of a flexible substrate so as to increase the thickness of some parts of the wiring board. However, for example, when the wiring board using this technique is dropped, an impact arising therefrom is transmitted to the wiring board, and wires connecting electronic components are eventually disconnected.

In the meantime, wiring structures in electronic devices are expected to be made highly flexible. For example, Patent Literature 2 describes a technique to provide high flexibility in wiring structure. This publication discloses a printed wiring board having a first substrate and a second substrate laminated on the first substrate, where the outline of the second substrate is different from that of the first substrate.

Even if the technique disclosed in Patent Literature 2 is employed, wires connecting electronic components are eventually disconnected when the printed board receives an impact such as from being dropped or the like and the impact reaches the wiring board.
Patent Literature 1: Unexamined Japanese Patent Application KOKAI Publication No. H05-152693
Patent Literature 2: WO 05/029934

### Disclosure of the Invention

### Problem to be Solved by the Invention

The present invention is to solve the above subject matter; namely, to provide a wiring board and its manufacturing method where the risk of rupture in the wiring that connects electronic components mounted on a wiring board is minimized when the wiring board receives an impact such as from being dropped or the like.

### Means for Solving the Problem

To achieve the above objective, a wiring board according to the first aspect of the present invention is structured by laminating a first substrate, a second substrate having a smaller mounting area than that of the first substrate, and a base substrate placed between the first substrate and the second substrate; and at least a portion of the periphery is made thinner than the central portion, vias are formed in at least either the first substrate or the second substrate, and in the base substrate the thickness of the portion bonded only to the first substrate is made less than that of the portion sandwiched between the first substrate and the second substrate.

Also, to achieve the above objective, a wiring board according to the second aspect of the present invention is structured by laminating a first substrate, a second substrate having a smaller mounting area than that of the first substrate, and a base substrate formed between the first substrate and the second substrate; and at least a portion of the periphery is made thinner than the central portion, vias are formed in at least either the first substrate or the second substrate, and at the base substrate, portions bonded only to the first substrate are formed intermittently.

Moreover, to achieve the above objective, a method of manufacturing a wiring board according to the third aspect of the present invention has a base-substrate forming step to form a base substrate; an insulation-layer forming step to form insulation layers positioned on both surfaces of the base substrate; a via forming step to form vias in the insulation layers; and a cutting step, by cutting the insulation layers, to form a first substrate and a second substrate that has a smaller mounting area than that of the first substrate, while making at least a portion of the periphery thinner than the central portion. Also, in the cutting step, a base substrate is cut in such a way that the thickness of the portion bonded only to the first substrate is made less than that of the portion sandwiched between the first substrate and the second substrate.

Furthermore, to achieve the above objective, a method of manufacturing a wiring board according to the fourth aspect of the present invention has a base-substrate forming step to form a base substrate; an insulation-layer forming step to form insulation layers positioned on both surfaces of the base substrate; a via forming step to form vias in the insulation layers; a cutting step, by cutting the insulation layer, to form a first substrate and a second substrate that has a smaller mounting area than that of the first substrate, while making at least a portion of the periphery thinner than the center portion. Also, in the cutting step, the base substrate is cut in such a way that the portions bonded only to the first substrate are formed intermittently.

### Effect of the Invention

When a wiring board according to the present invention is, e.g., dropped and is subject to an impact induced thereby, wires connecting electronic components mounted on the wiring board are not easily disconnected.

### Brief Description of Drawings

Fig. 1A is a side view illustrating a wiring board according to an embodiment of the present invention.
Fig. 1B is a plan view illustrating a wiring board according to an embodiment of the present invention.
Fig. 2 is a cross-sectional view illustrating a wiring board according to an embodiment of the present invention.
Fig. 3 is a cross-sectional view illustrating a wiring board according to an embodiment of the present invention.
Fig. 4 is a cross-sectional view illustrating a wiring board according to an embodiment of the present invention.
Fig. 5 is a cross-sectional view illustrating a wiring board according to an embodiment of the present invention.
Fig. 6 is a cross-sectional view illustrating a wiring board according to an embodiment of the present invention.
Fig. 7A illustrates a step of a method to manufacture a wiring board according to an embodiment of the present invention.
Fig. 7B illustrates a step of a method to manufacture a wiring board according to an embodiment of the present invention.
Fig. 7C illustrates a step of a method to manufacture a wiring board according to an embodiment of the present invention.
Fig. 7D illustrates a step of a method to manufacture a wiring board according to an embodiment of the present invention.
Fig. 7E illustrates a step of a method to manufacture a wiring board according to an embodiment of the present invention.
Fig. 7F illustrates a step of a method to manufacture a wiring board according to an embodiment of the present invention.
Fig. 7G illustrates a step of a method to manufacture a wiring board according to an embodiment of the present invention.
Fig. 7H illustrates a step of a method to manufacture a wiring board according to an embodiment of the present invention.
Fig. 7I illustrates a step of a method to manufacture a wiring board according to an embodiment of the present invention.
Fig. 7J illustrates a step of a method to manufacture a wiring board according to an embodiment of the present invention.
Fig. 7K illustrates a step of a method to manufacture a wiring board according to an embodiment of the present invention.
Fig. 7L illustrates a step of a method to manufacture a wiring board according to an embodiment of the present invention.
Fig. 7M illustrates a step of a method to manufacture a wiring board according to an embodiment of the present invention.
Fig. 7N illustrates a step of a method to manufacture a wiring board according to an embodiment of the present invention.
Fig. 7O illustrates a step of a method to manufacture a wiring board according to an embodiment of the present invention.
Fig. 7P is a view illustrating wiring boards according to an embodiment of the present invention.
Fig. 8 is a cross-sectional view of a wiring board according to an embodiment of the present invention.
Fig. 9 illustrates a step of a method to manufacture a wiring board according to an embodiment of the present invention.
Fig 10 is a cross-sectional view of a wiring board according to an embodiment of the present invention.
Fig. 11 is a cross-sectional view of a wiring board according to an embodiment of the present invention.
Fig. 12 is a cross-sectional view of a wiring board according to an embodiment of the present invention.
Fig. 13 is a cross-sectional view of a wiring board according to an embodiment of the present invention.
Fig. 14 is a cross-sectional view of a wiring board according to an embodiment of the present invention.
Fig. 15 is a cross-sectional view of a wiring board according to an embodiment of the present invention.
Fig. 16A is a cross-sectional view of a wiring board according to an embodiment of the present invention.
Fig. 16B is a cross-sectional view of a wiring board according to an embodiment of the present invention.

### Explanation of Reference Numerals

- 1: first substrate
- 2: second substrate
- 3: base substrate
- 7: keypad
- 8: electronic chip
- 9: solder
- 10: gold pad
- 13: multi-layer section
- 14: fewer-layer section
- 19: wiring board according to the present invention
- 44: via
- 51: copper foil
- 52: dummy core
- 54: copper foil
- 55: core
- 61: copper foil
- 62: prepreg
- 63: through-hole
- 71: copper foil
- 72: epoxy resin
- 81: epoxy resin
- 82: copper foil
- 83: solder-resist
- 91: gold plating
- 92: electronic component

### Best Mode for Carrying Out the Invention

### (FIRST EMBODIMENT OF A WIRING BOARD ACCORDING TO A SPECIFIC EXAMPLE OF THE PRESENT INVENTION)

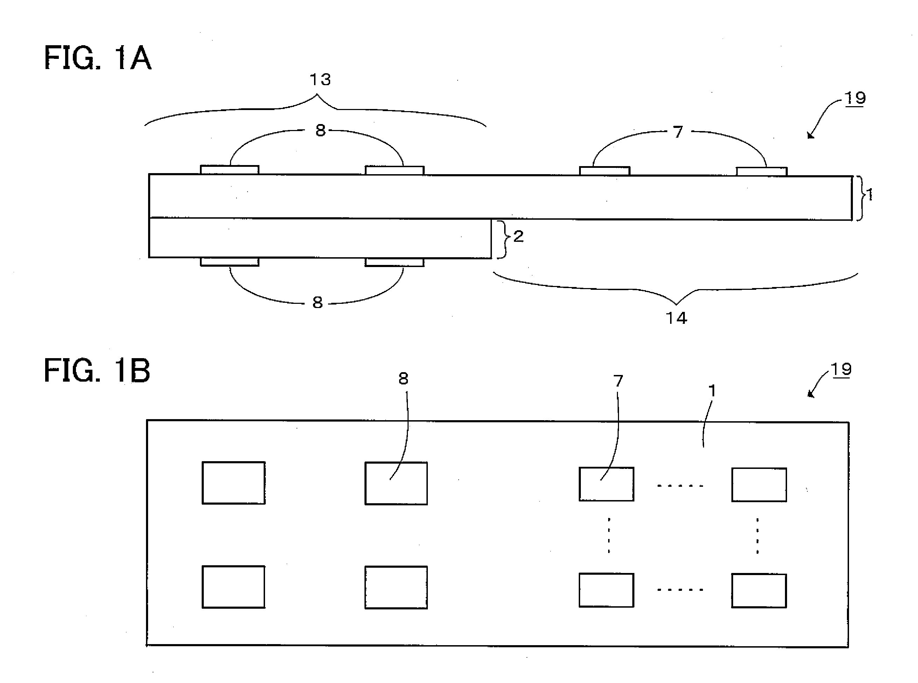

In the following, an embodiment of a wiring board according to a specific example of the present invention is described with reference to the drawings.
As shown in Fig. 1A, wiring board 19 according to a specific example of the present invention has a different thickness on one edge from that on the other edge. The number of layers in the section having a different thickness differs from the number of layers in the thinner section. Namely, wiring board 19 has thick multi-layer section 13 and relatively thin fewer-layer section 14. Multi-layer section 13 is structured by laminating two layers, first substrate 1 and second substrate 2. Fewer-layer section 14 has first substrate 1, which is extended from multi-layer section 13.

As shown in Figs. 1A and 1B, first substrate 1 and second substrate 2 have the same width and different lengths, and one end of first substrate 1 and one end of second substrate 2 are aligned. The thickness of first substrate 1 is made less than that of the central portion, which is the total thickness of first substrate 1, base substrate 3 and second substrate 2. Likewise, the thickness of second substrate 2 is made less than that of the central portion, and the thickness of base substrate 3 is made less than that of the central portion. First substrate 1 and second substrate 2 are each made of non-pliable base material such as epoxy resin.

On the surfaces (mounting surfaces) of first substrate 1 and second substrate 2, connection pads to connect electronic components are formed; on the surfaces (mounting surfaces) and inside first substrate 1 and second substrate 2, wiring patterns to structure electrical circuits are formed.

On the mounting surfaces of first substrate 1 and second substrate 2, electronic components 7, 8 are arranged and connected to connection pads according to their requirements. Electronic components 7, 8 are connected with each other through connection pads and wiring patterns.

Wiring board 19 is placed, for example, in the casing of a cell phone device. In such a circumstance, electronic component 7 placed in fewer-layer section 14 is structured, for example, with the keypad of a keyboard; and electronic component 8 placed in multi-layer section 13 is structured with an electronic chip, IC module, functional components and others. Also, in the step portion formed by multi-layer section 13 and fewer-layer section 14, for example, a thin-type battery is placed.

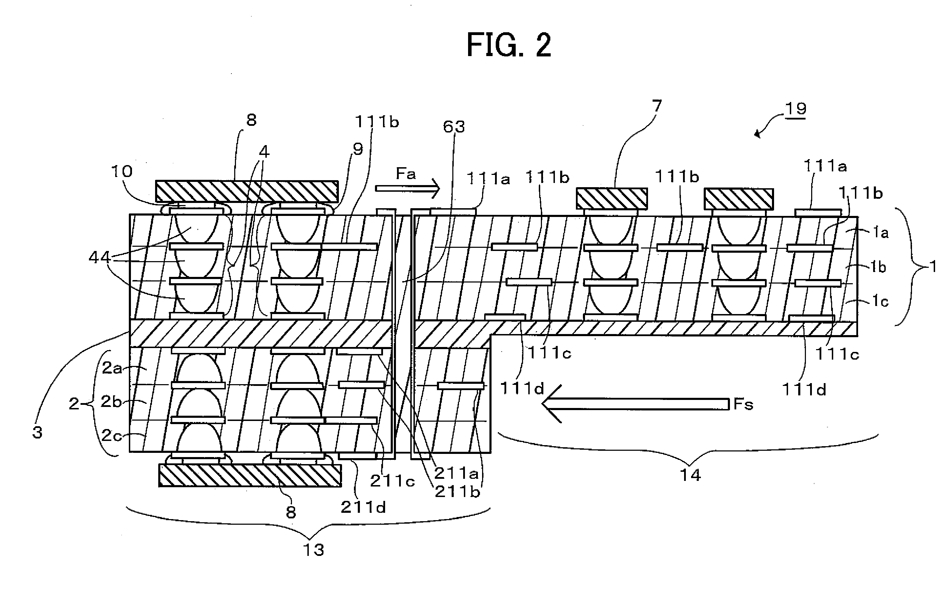

Next, a detailed structure of wiring board 19 having the above overall structure is described in reference to Fig. 2. As illustrated, first substrate 1 and second substrate 2 are laminated with base substrate 3 in between. One end (the left end as illustrated in the drawing) of base substrate 3 is made to be flush with first substrate 1 and second substrate 2. Base substrate 3 is made of a highly rigid material such as glass epoxy resin. Base substrate 3 is made 50-100 µm, preferably about 100 µm.

In base substrate 3, the thickness of the portion bonded only to first substrate 1 is made less than that of the portion sandwiched between first substrate 1 and second substrate 2. Namely, in base substrate 3, the thickness of the portion positioned at fewer-section 14 is made less than that of the portion positioned at multi-layer section 13. In this example, the thickness of base substrate 3 positioned at fewer-layer section 14 is made one-half of the thickness of base substrate 3 positioned at multi-layer section 13. In addition, the thickness of base substrate 3 positioned at fewer-layer section 14 is preferably made 0.2-0.5 times as thick as that of base substrate 3 positioned at multi-layer section 13.

First substrate 1 is structured by laminating multiple insulation layers (1a, 1b, 1c). Each insulation layer is made of epoxy resin or the like with a thickness approximately 10 µm-60 µm. On the upper surface of insulation layer (1a), between epoxy-resin layers (1a) and (1b), between insulation layers (1b) and (1c) and on the lower surface of insulation layer (1c), wiring patterns (111a, 111b, 111c, 111d) are formed respectively. Each wiring pattern (111a, 111b, 111c, 111d) electrically connects required portions inside the circuit substrate.

Second substrate 2 is also structured by laminating multiple insulation layers (2a, 2b, 2c) made of epoxy resin or the like with a thickness approximately 10 µm - 60 µm. On the lower surface of insulation layer (2a), between epoxy-resin layers (2a) and (2b), between insulation layers (2b) and (2c) and on the upper surface of insulation layer (2c), wiring patterns (211 a, 211b, 211 c, 211 d) are formed respectively. Each wiring pattern (211 a, 211b, 211c, 211d) electrically connects required portions inside the circuit substrate.

Keypad 7 is placed on the conductive pattern formed on the surface of fewer-layer section 14. Further, using solder 9, electronic chip 8 is anchored and connected to wiring patterns and built-up vias 4 through connection pads 10. For solder 9, Sn/Ag/Cu was used.

Moreover, through-hole 63 is formed, penetrating base substrate 3, further penetrating first substrate 1 and second substrate 2, and connecting wiring pattern (111a) of first substrate 1 and wiring pattern (211 d) of second substrate 2. The inner surface of through-hole 63 is plated so as to electrically connect wiring patterns. The area enveloped by plated through-hole 63 may be filled with resin such as epoxy-resin.

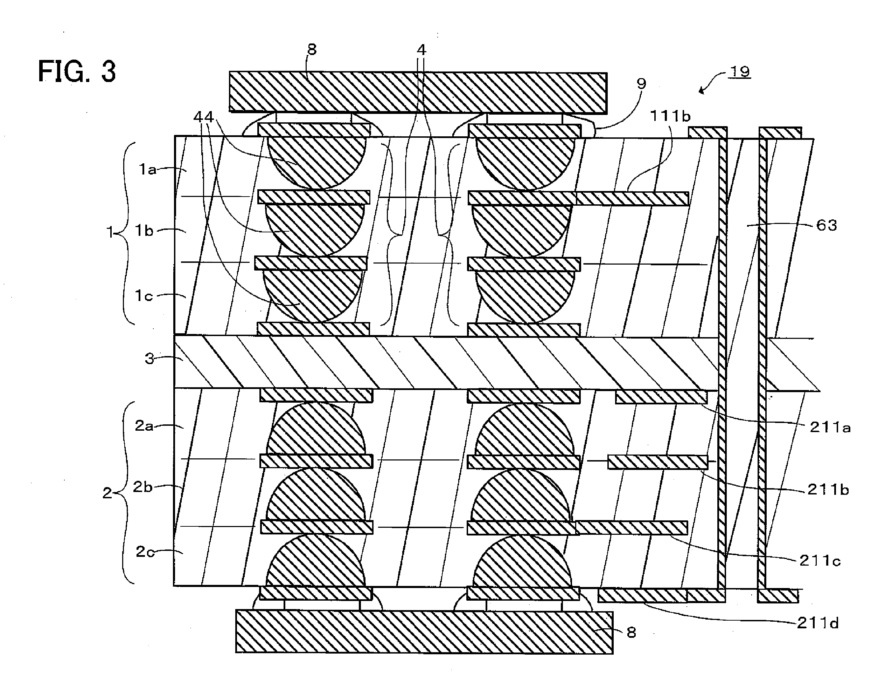

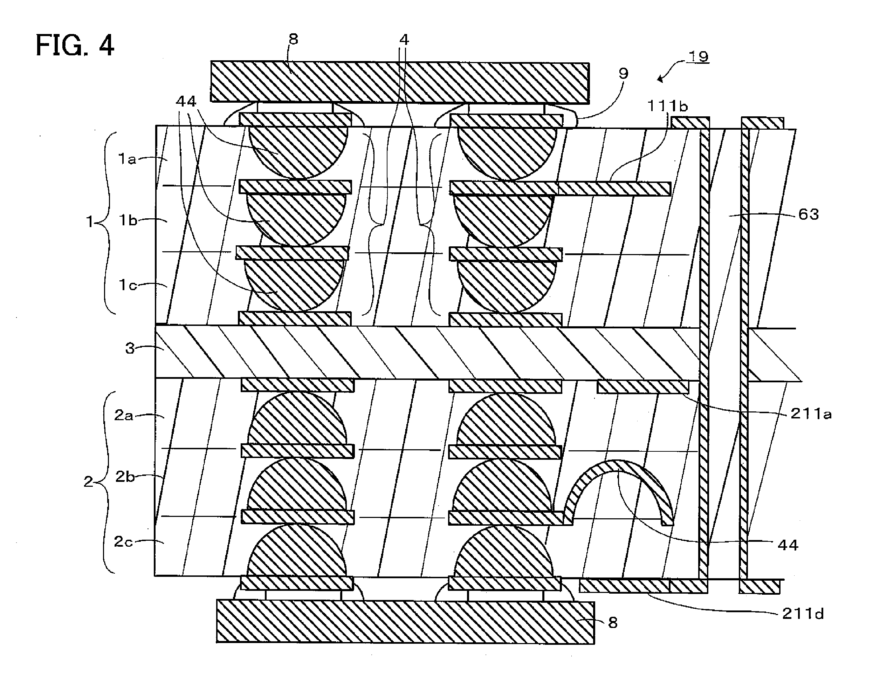

In first substrate 1 and second substrate 2, multiple built-up vias 4 are formed. Built-up vias 4 are structured by stacking vias 44 formed in each insulation layer (1a-1c, 2a-2c). Built-up vias 4 connect required portions of wiring patterns (111a-111d) and also connect required portions of wiring patterns (211a-211d). On the inner surface of each via 44 forming built-up via 4, a conductive layer made of plated copper or the like is formed. As shown in Fig. 3, the interior of each via 44 is filled with conductor such as copper. However, as shown in Fig. 4, the interior of via 44 may be filled with resin such as epoxy-resin.

Wiring board 19 having the above structure, for example, transmits operational signals from keypad 7 to an IC chip through built-up vias 4, wiring patterns (111a-111d) and through-hole 63, and the signals are then processed at the IC chip. By doing so, varieties of signal processing may be conducted.

Also, as described above, wiring board 19 is structured with multi-layer section 13 and fewer-layer section 14 and has a step portion. And at the lower portion of fewer-layer section 14, a large-volume component such as a cell-phone battery may be placed.

Base substrate 3 is made of highly rigid material such as glass-epoxy resin. Multi-layer section 13, because relatively thick base substrate 3 is positioned there, is highly rigid compared with fewer-layer section 14. On the other hand, fewer-layer section 14 is relatively flexible compared with multi-layer section 13. Thus, it is possible to place electronic components according to the reliability level they require when being placed.

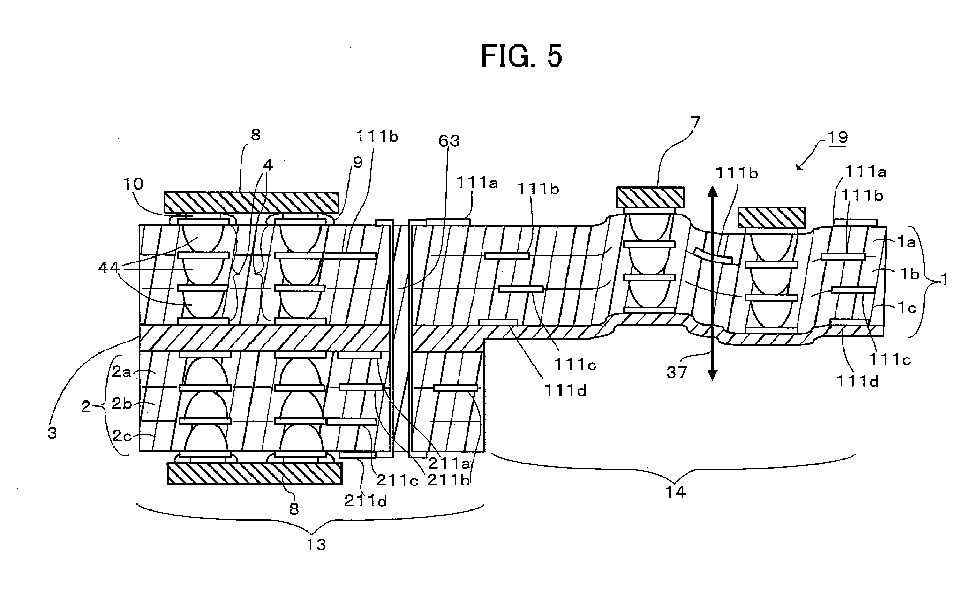

Also, when the electronic device is dropped and an impact or the like is exerted on wiring board 19, due to the relative flexibility of fewer-layer section 14 compared with multi-layer section 13, fewer-layer section 14 vibrates as shown by arrow 37 in Fig. 5. Since portions of fewer-layer section 14 vibrate, the impact from being dropped or the like is converted to vibration motion energy, and the impact is absorbed accordingly. As a result, the risk of rupture in the wiring that connects the electronic components mounted on wiring board 19 may be minimized.

Also, built-up via 4 has a stacked via structure with laminated multiple vias 44. By making such a stacked interlayer connection structure, the wiring length is shortened, and thus preferable for mounting electronic components requiring large amounts of electricity.

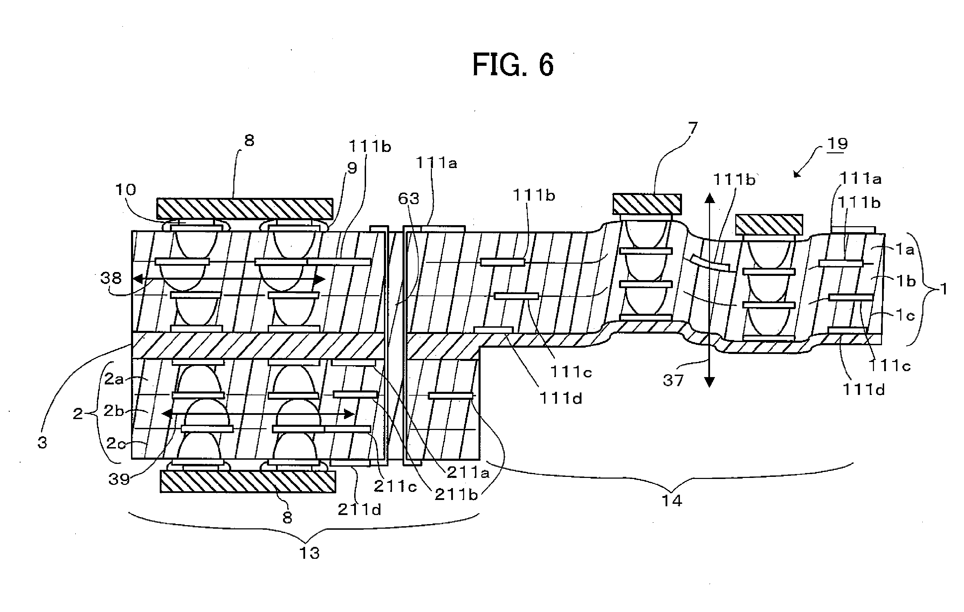

Moreover, built-up via 4 has a certain degree of mobility. Therefore, when the electronic device is dropped and an impact is exerted, for example, on wiring board 19, as shown by arrows 38, 39 in Fig. 6, through the movement of built-up via 4, the impact may be absorbed at built-up via 4. As a result, the risk of rupture of the wiring that connects the electronic components mounted on wiring board 19 may be minimized.

In addition, through-hole 63, which penetrates base substrate 3, is formed and the inner surface of through-hole 63 is plated (or filled with resin). Thus, as shown in Fig. 2, if shearing force (Fs) is exerted on the wiring board from a horizontal direction, through-hole 63 may counter the shearing force, thus preventing first substrate 1 and second substrate 2 from sliding.

Further, the portion of base substrate 3 bonded only to fewer-layer section 14 prevents wiring board 19 from warping. Multi-layer section 13, having a multi-layered structure, is made rigid compared with fewer-layer section 14. Thus, at multi-layer section 13, warping seldom occurs. On the other hand, fewer-layer section 14 is made flexible compared with multi-layer section 13. Thus, at fewer-layer section 14, warping may possibly occur. However, at the lower portion of fewer-layer section 14, thin base substrate 3 is bonded. Thin base substrate 3 supports fewer-layer section 14. Therefore, warping at fewer-layer section 14 may be minimized.

### (METHOD OF MANUFACTURING A WIRING BOARD ACCORDING TO A SPECIFIC EXAMPLE OF THE PRESENT INVENTION)

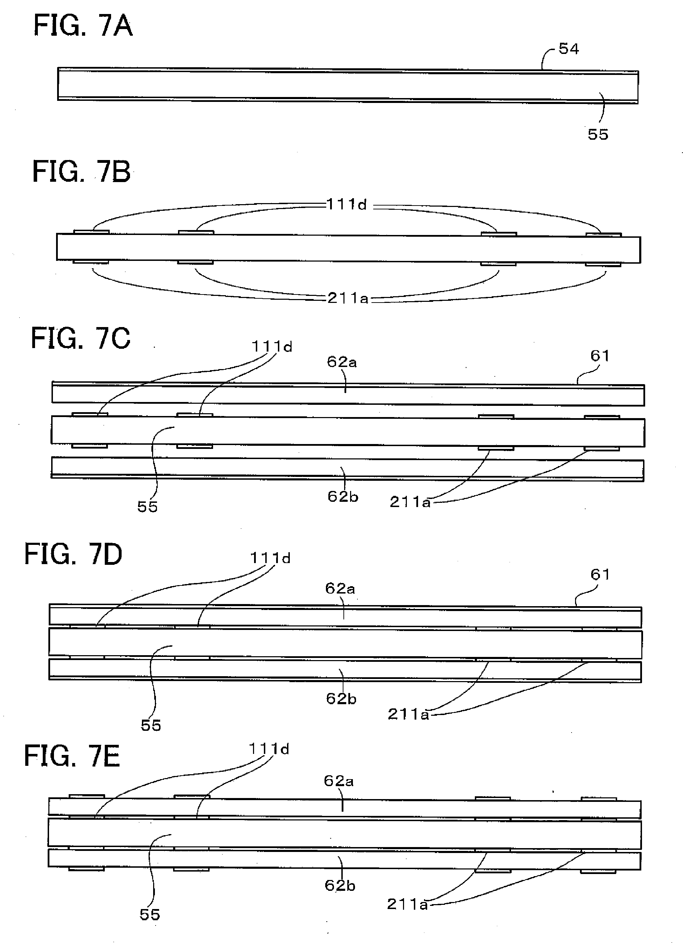

In the following, a method of manufacturing wiring board 19 according to the present invention is described.
First, as shown in Fig. 7A, core 55, which functions as base substrate 3, is prepared. Core 55 is made, for example, of highly rigid material such as glass-epoxy resin. On both surfaces of core 55, copper foil 54 is deposited.

Next, as shown in Fig. 7B, by patterning copper foil 54, conductive patterns (111d, 211a) are formed to structure wiring patterns.

Next, as shown in Fig. 7C, on the top and bottom of core 55, prepreg (62a, 62b) are laminated. For prepreg (62a, 62b), low-flow prepreg impregnated with low-flow epoxy-resin is preferred. Then, on the surfaces of prepreg (62a, 62b), copper foil 61 is placed.

Next, as shown in Fig. 7D, on the laminate shown in Fig. 7C, pressure is applied. Pressure is, for example, applied by hydraulic power using hydraulic pressing equipment under conditions calling for a temperature of 200°C, pressure of 40 kgf and pressing time of three (3) hours. By doing so, resin is squeezed from the prepreg, and the prepreg and core material are integrated accordingly. For applying pressure, vacuum pressing may be employed instead of hydraulic pressing. By conducting vacuum pressing, bubbles may be prevented from mixing into the resin which structures the insulation layers. Vacuum pressing is conducted, for example, for an hour. Peak heating temperature is set, for example, at 175°C. Vacuum-pressing pressure is set, for example, at 3.90 x 10⁶ [Pa].

Next, as shown in Fig. 7E, by removing the unnecessary portions of copper foil 61, inner-layer patterns are formed.

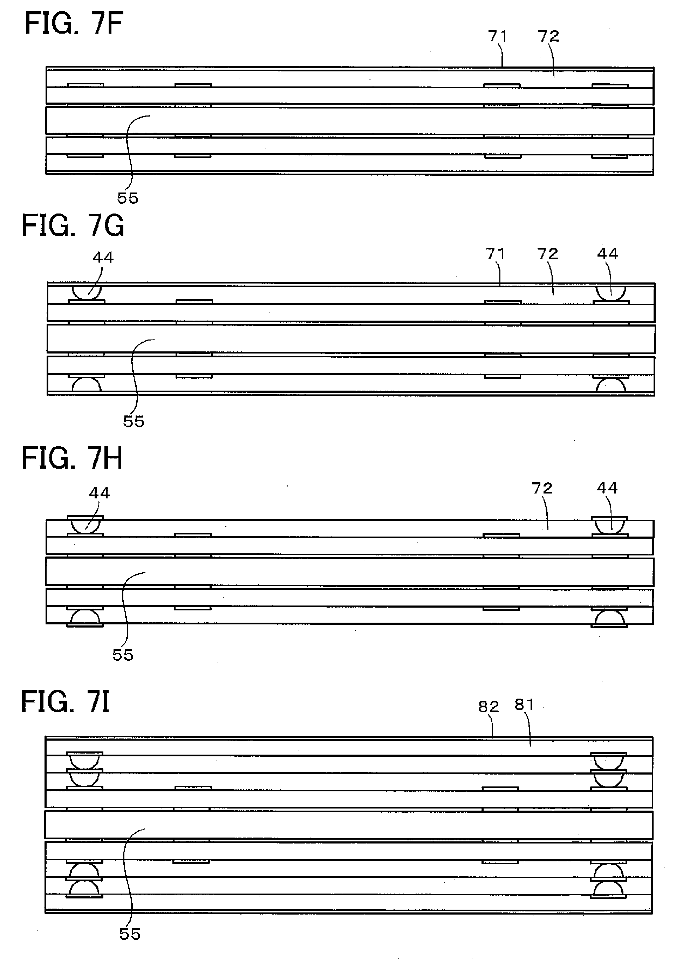

Next, as shown in Fig. 7F, epoxy resin 72 is further laminated to form inner layers.
On both surfaces of epoxy resin 72, copper foil 71 is formed.

Next, as shown in Fig. 7G, vias 44 are formed. Namely, in epoxy resin 72 made of insulation resin, openings for via-holes are formed. Those openings may be formed by beaming a laser. Then, to remove resin residue remaining on the side and bottom surfaces of the openings formed by beaming a laser, a desmear treatment is performed. The desmear treatment is performed by an oxygen plasma discharge treatment, a corona discharge treatment, an ultra-violet laser treatment or an exima laser treatment. In the openings formed by beaming a laser, conductive material is filled to form filled via holes. As for conductive material, conductive paste or metal plating formed by an electrolytic plating process is preferred. For example, vias 44 are filled with conductor such as copper plating. To reduce the manufacturing cost and improve the productivity by simplifying the filled-via forming step, filling with a conductive paste is preferred. For example, a conductive paste (such as thermo-set resin containing conductive particles) may be printed by screen-printing, filled in vias 44 and cured. By filling the interiors of vias 44 with the same conductive paste material, connection reliability when thermo-stress is exerted on vias 44 may be improved. On the other hand, regarding connection reliability, metal plating formed by an electrolytic plating process is preferred. Especially, electrolytic copper plating is preferred.

Next, as shown in Fig. 7H, by removing the unnecessary portions of copper foil 71, inner-layer patterns are formed.

Next, as shown in Fig. 7I, after inner layers and vias are further formed, epoxy-resin 81 is laminated to form outer layers. On both surfaces of epoxy-resin 81, copper foil 82 is deposited. Here, a copper foil sheet containing resin (Resin Cupper Film: RCF) may be positioned and pressed.

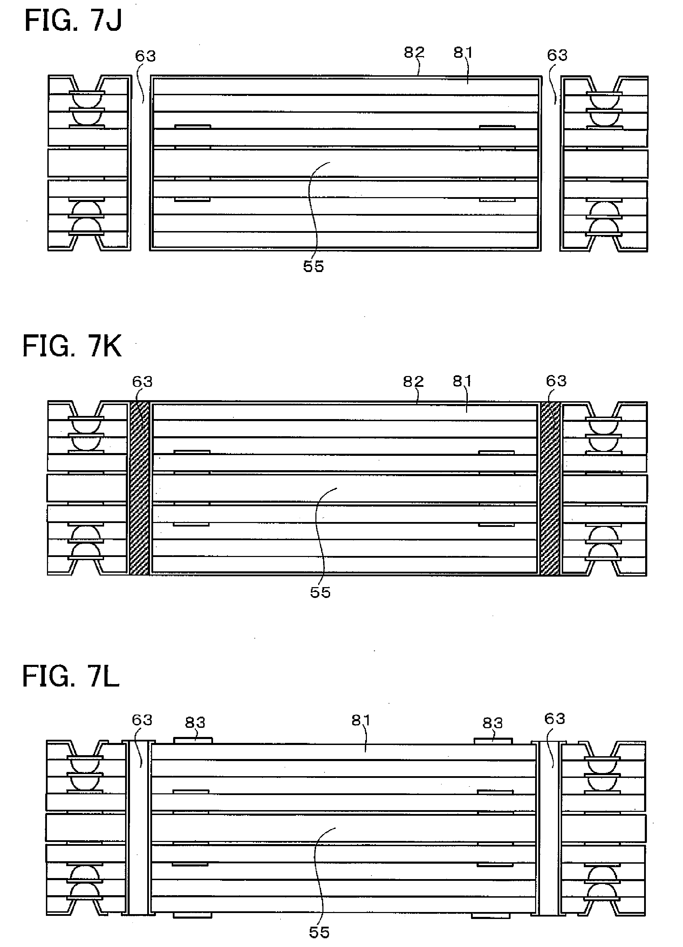

Next, as shown in Fig. 7J, vias are formed in the RCF. Further, in the laminate shown in Fig. 7I, holes are opened by a drill. The holes penetrate the base substrate and insulation layers formed on both sides of the base substrate. By doing so, through-holes 63 are formed. Then, using copper plating or the like, the interiors of the vias and through-holes 63 are filled with conductor. Also, according to requirements, by patterning the surface copper foil, conductive patterns are formed.

Next, as shown in Fig. 7K, the interiors of through-holes 63 are filled with epoxy resin, and by removing unnecessary portions of copper foils 82, outer-layer patterns are formed.

Next, as shown in Fig. 7L, solder resist 83 is formed. Here, the solder resist indicates heat-resistant coating material, which is used when applying solder to cover the portions to keep the solder from adhering. For solder-resist varieties, photo-setting-type solder resist and thermo-setting-type solder resist may be used. For a coating method, a screen-printing method or curtain-coating method may be used.

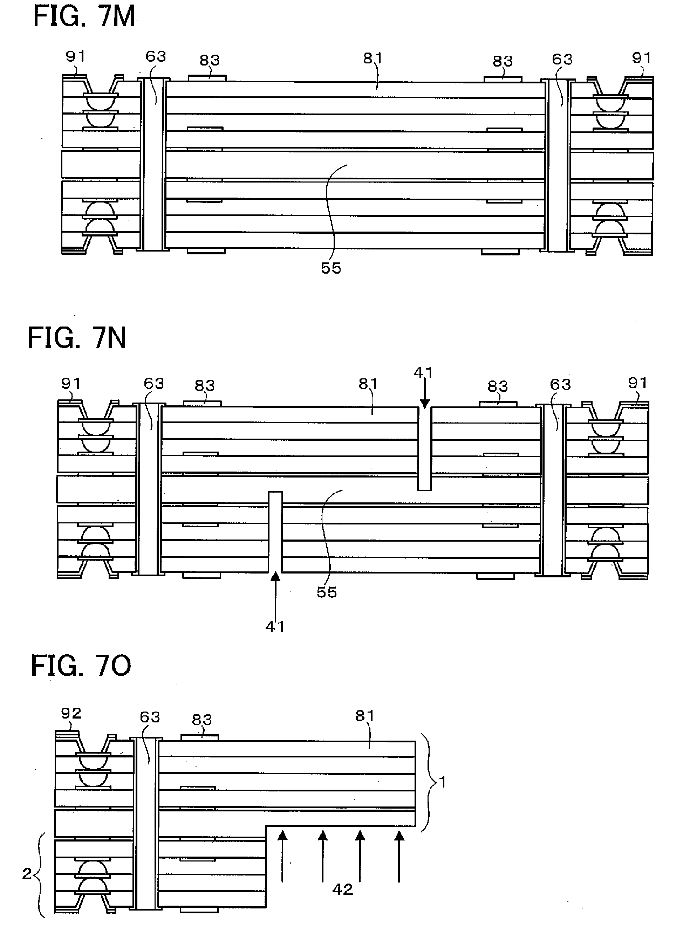

Next, as shown in Fig. 7M, to protect outer-layer patterns, gold plating 91 is performed by chemical plating. Other than chemical plating, methods such as fusion plating and electrical plating may be used. Moreover, other than gold plating, alloy plating may be used.

Next, as shown by arrows 41 in Fig. 7N, laser beams from laser processing equipment, for example CO₂ laser, are beamed to cut the insulation layers and the copper foil sheet containing resin (RCF).

Furthermore, as shown by arrows 42 in Fig. 7O, laser beams from laser processing equipment are beamed to cut the thickness of a portion of base substrate 3 bonded only to first substrate 1. Also, by cutting as indicated by arrows 42, first substrate 1 and second substrate 2 having a smaller mounting area than that of first substrate 1 are obtained. As shown in Fig. 7O, electronic component 92 is mounted. Electronic component 92 is electronic chip 8 or keypad 7.

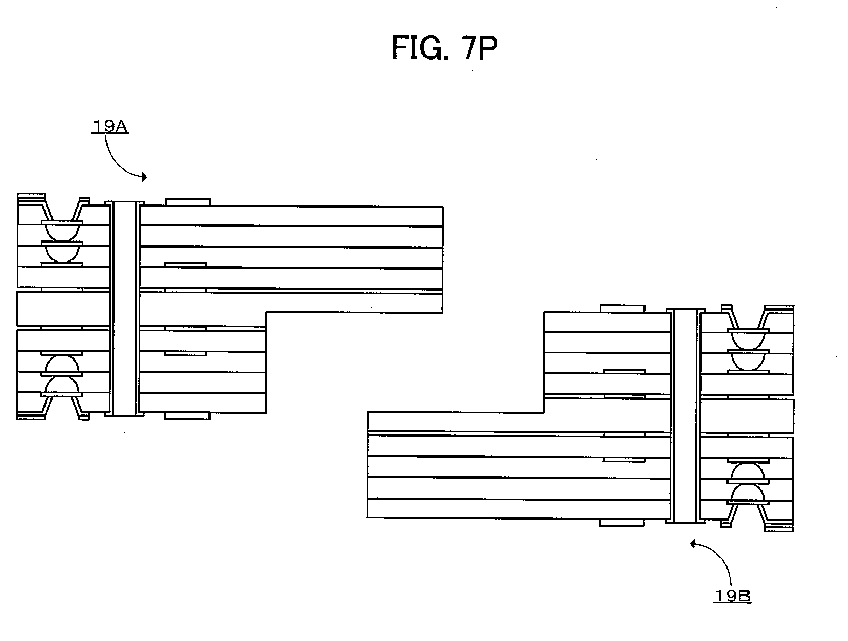

And, as shown in Fig. 7P, wiring board (19A) and wiring board (19B) are separated for use. As described, a sheet of core 55 is repeatedly laminated with epoxy resin, and by cutting it with a laser, two wiring boards (19A, 19B) are obtained from one sheet of core. Thus, wiring boards may be manufactured efficiently.

### (SECOND EMBODIMENT OF A WIRING BOARD ACCORDING TO A SPECIFIC EXAMPLE OF THE PRESENT INVENTION)

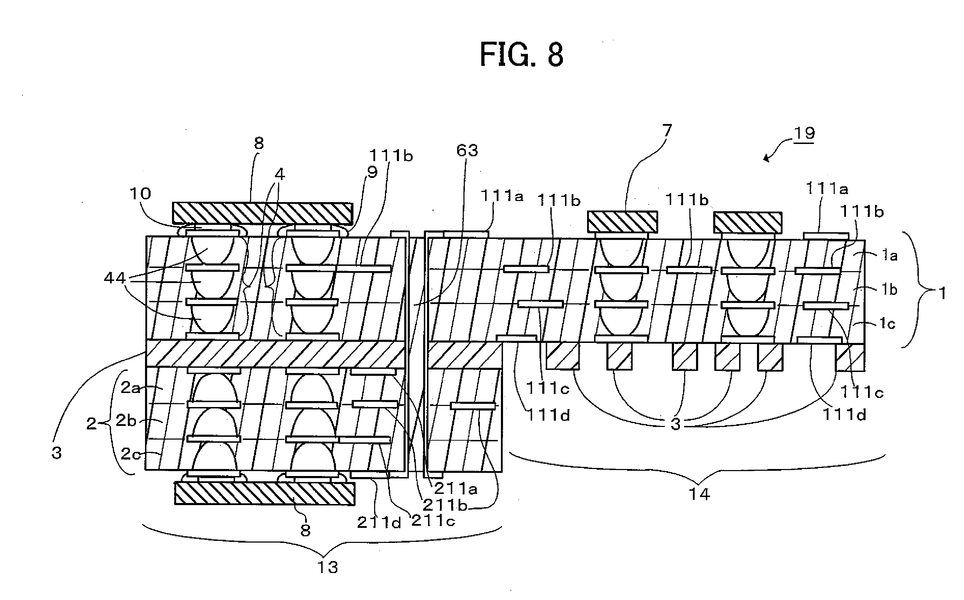

In the following, as shown in Fig. 8, a wiring board according to the Second Embodiment of the present invention is described. In the Second Embodiment, portions of base substrate 3 bonded only to first substrate 1 are formed intermittently. Namely, portions of base substrate 3 positioned beneath fewer-layer section 14 are formed intermittently.

At fewer-layer section 14, since base substrate 3 is formed intermittently, fewer-layer section 14 is flexible compared with multi-layer section 13. Due to the flexibility of fewer-layer section 14, fewer-layer section 14 vibrates. Then, since fewer-layer section 14 vibrates, the impact is converted to vibration motion energy, and the impact is absorbed. As a result, connection reliability of electronic components, which are mounted on first substrate 1 that forms fewer-layer section 14, is enhanced.

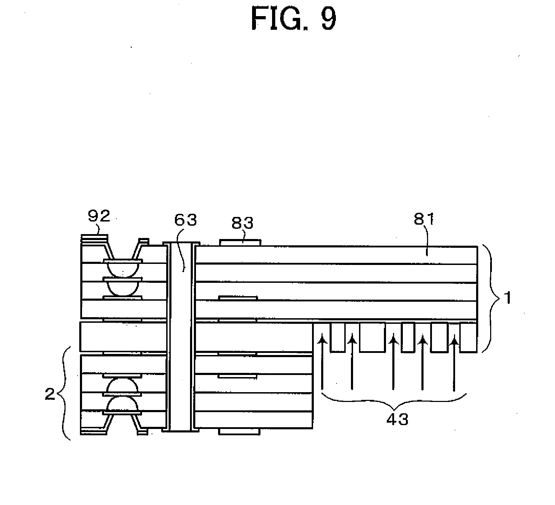

The method of manufacturing a wiring board according to the Second Embodiment is the same as the manufacturing method of a wiring board according to the First Embodiment with reference to Figs. 7A-7N. Instead of Fig. 7O, as shown in Fig. 9, by laser beams 43, base substrate 3 is cut intermittently.

### (THIRD EMBODIMENT OF A WIRING BOARD ACCORDING TO A SPECIFIC EXAMPLE OF THE PRESENT INVENTION)

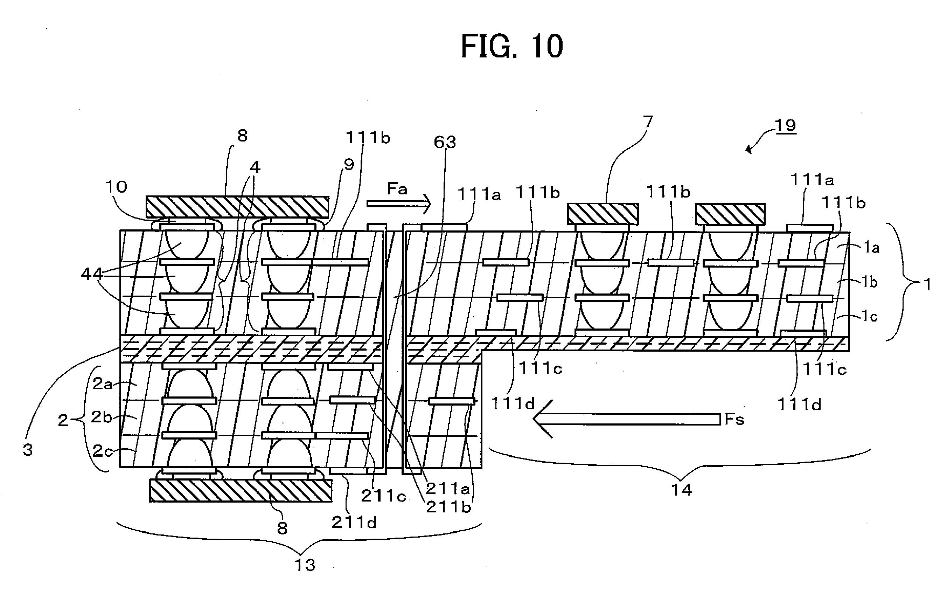

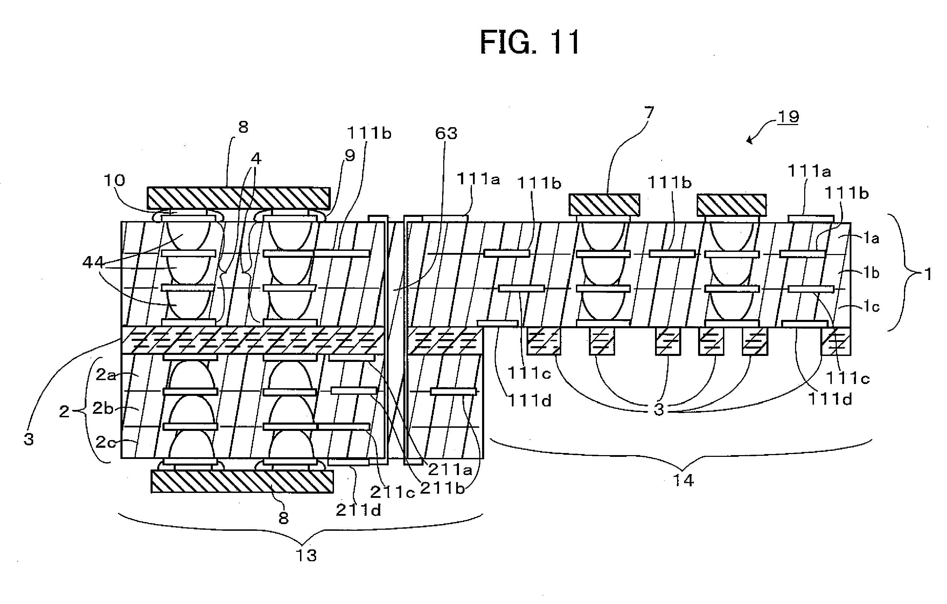

In the First Embodiment, base substrate 3 was made of glass-epoxy resin. However, as shown in Figs. 10 and 11, in the Third Embodiment, base substrate 3 is formed with base material of resin-impregnated inorganic fabric. First substrate 1 and second substrate 2 are structured with pliable resin. By being structured as such, since base substrate 3 contains base material of resin-impregnated inorganic fabric, tolerance to warping may be enhanced.

The base material of resin-impregnated inorganic fabric is made by curing a prepreg. Prepreg is made by impregnating glass-cloth inorganic fabric with epoxy-resin, then preliminarily thermosetting the resin to advance the level of curing. The resin used to make prepreg is preferred to have low-flow characteristics, but one with regular-flow characteristics may be used as well. Also, the prepreg may be formed by reducing the amount of epoxy-resin impregnated in the glass-cloth inorganic fabric.

As for the inorganic fabric, it is not limited to glass cloth; for example, alumina fabric, carbon fabric (carbon fiber), silicon carbide fabric or silicon nitride fabric may also be used.

In the method of manufacturing a wiring board according to the Third Embodiment, referring to Fig. 7A, as the material to form core 55, base material of resin-impregnated inorganic fabric is used. Also, referring to Figs. 7C, 7F and 7I, as the resin to laminate, pliable resin is used. The rest is the same as the method of manufacturing a wiring board according to the First Embodiment or the Second Embodiment.

### (FOURTH EMBODIMENT OF A WIRING BOARD ACCORDING TO A SPECIFIC EXAMPLE OF THE PRESENT INVENTION)

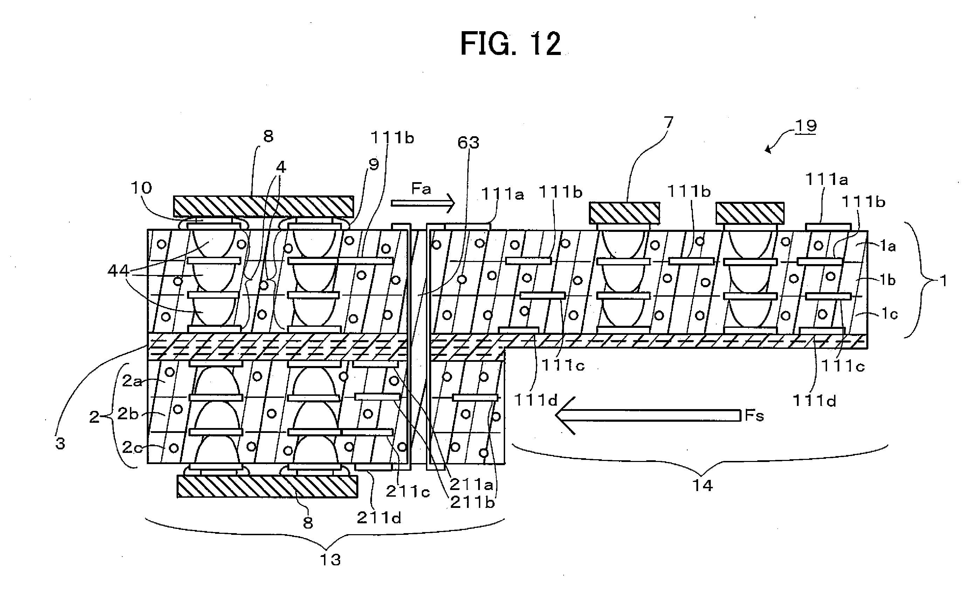

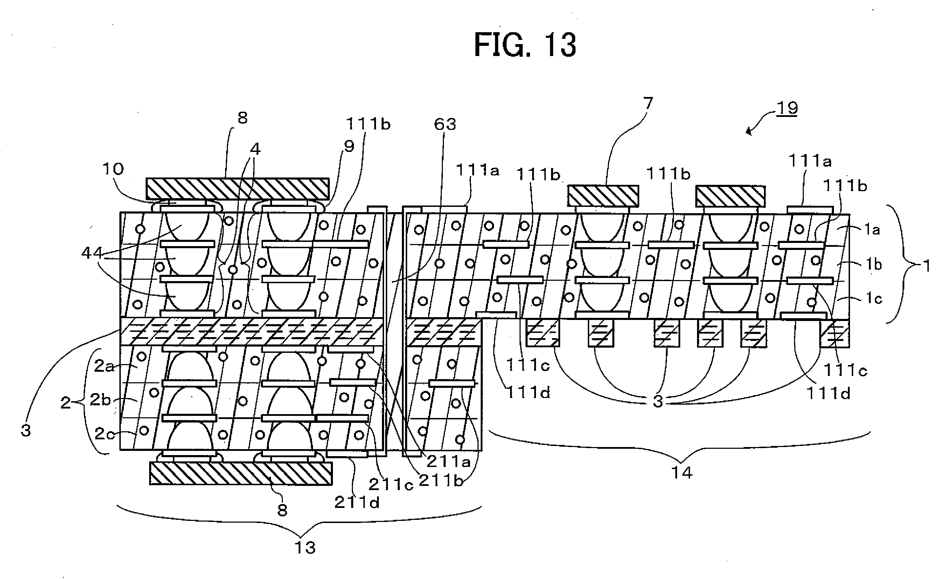

In the above-described First Embodiment, base substrate 3 was made of glass-epoxy resin. And first substrate 1 and second substrate 2 were made of epoxy resin. However, the combination of material for base substrate 3 and material for first substrate 1 and second substrate 2 is not limited to such. As shown in Figs. 12-13, in the Fourth Embodiment, base substrate 3 is formed with base material of resin-impregnated inorganic fabric; and first substrate 1 and second substrate 2 are formed with resin containing inorganic filler. By forming so, since base substrate 3 contains base material of resin-impregnated inorganic fabric, tolerance to warping may be improved. Accordingly, when an electronic device such as a cell phone receives an impact from being dropped or the like, the risk of rupture in the wiring that connects electronic components mounted in the wiring board may be minimized.

Resin containing inorganic filler may be made by combining silica filler or glass filler with epoxy resin. In addition to epoxy resin, or other than epoxy resin, polyimide, polycarbonate, polybutylene-telephtarate or polyacrylate may be used.

For silica filler, fused silica (SiO₂) or crystalline silica (SiO₂) may be used. Also, for glass filler, aluminum oxide (Al₂O₃), magnesium oxide (MgO), boron nitride (BN), or aluminum nitride (AlN) may be used. Furthermore, for inorganic filler, it is not limited to silica filler or glass filler; antimony trioxide, antimony pentaxide or magnesium hydroxide may be used.

In the method of manufacturing a wiring board according to the Fourth Embodiment, referring to Fig. 7A, as the material to form core 55, base material of resin-impregnated inorganic fabric is used. In addition, for the resin to be laminated in reference to Figs. 7C, 7F and 7I, resin containing inorganic filler is used. The rest is the same as the method of manufacturing a wiring board according to the First Embodiment or the Second Embodiment.

### (Fifth Embodiment of A Wiring Board According To A Specific Example of The Present Invention)

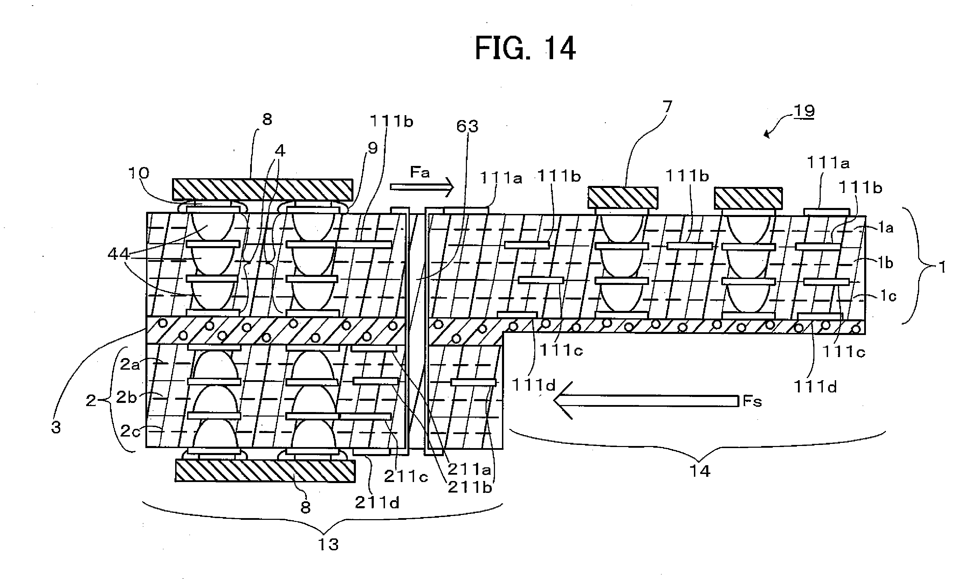

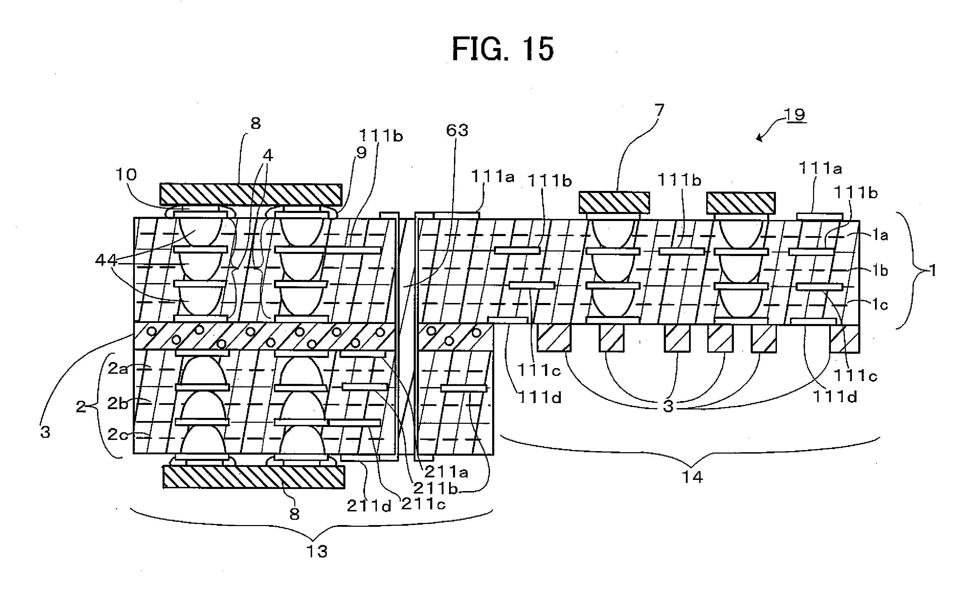

In the above-described First Embodiment, base substrate 3 was made of glass-epoxy resin. And first substrate 1 and second substrate 2 were made of epoxy resin. However, a combination of the material for base substrate 3 and the material for first substrate 1 and second substrate 2 is not limited to such. As shown in Figs. 14-15, in the Fifth Embodiment, base substrate 3 is formed with resin containing inorganic filler; and first substrate 1 and second substrate 2 are formed with base material of resin-impregnated inorganic fabric. By forming so, since at least either first substrate 1 or second substrate 2 is reinforced with inorganic fabric, tolerance to warping may be improved. Accordingly, when an electronic device such as a cell phone receives an impact from being dropped or the like, the risk of rupture in the wiring that connects electronic components mounted in the wiring board may be minimized.

The above-described inorganic material such as inorganic fabric or inorganic filler has a small coefficient of thermal-expansion and small elasticity compared with resin made of organic material. Accordingly, when inorganic material such as inorganic fabric or inorganic filler is combined, alignment gaps between connection lands may be reduced.

In the method of manufacturing a wiring board according to the Fifth Embodiment, referring to Fig. 7A, as the material to form core 55, resin containing inorganic filler is used. In addition, for the resin to be laminated in reference to Figs. 7C, 7F and 7I, a base material of resin-impregnated inorganic fabric is used. The rest is the same as the method of manufacturing a wiring board according to the First Embodiment or the Second Embodiment.

### (Other Examples of the Present Invention)

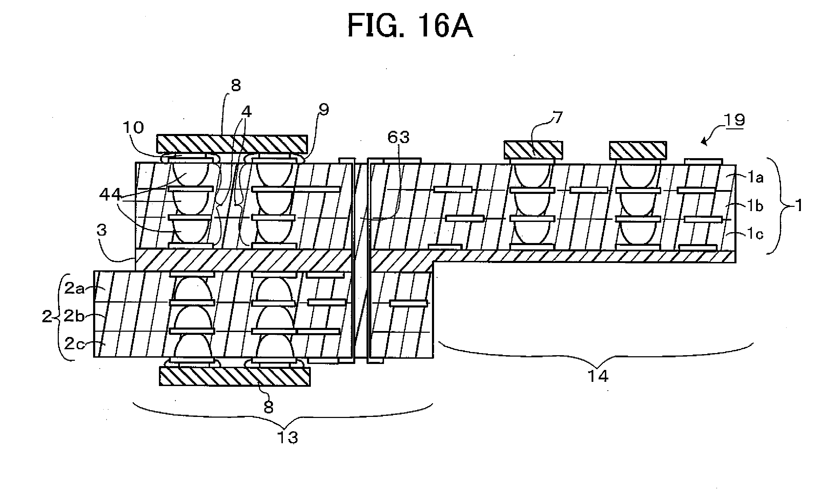

In a wiring board according to the above embodiments, an edge of first substrate 1 and an edge of second substrate 2 were aligned. However, this is not the only embodiment. As shown in Fig. 16A, an edge of second substrate 2 may protrude from an edge of first substrate 1. Here, the thickness of second substrate 2 is less than that of the central portion; similarly, the thickness of first substrate 1 is less than that of the central portion; and the thickness of base substrate 3 is less than that of the central portion.

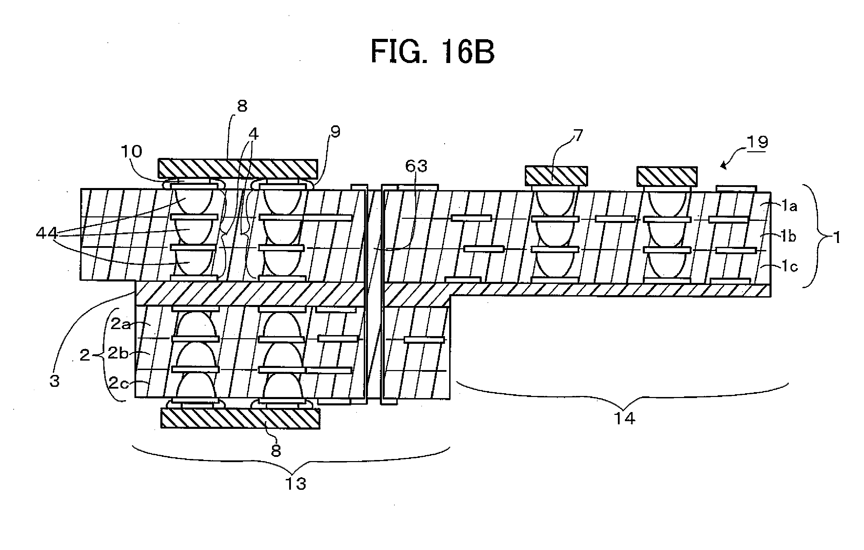

Also, as shown in Fig. 16B, an edge of first substrate 1 may protrude from an edge of second substrate 2. Here, the thickness of first substrate 1 is less than that of the central portion; similarly, the thickness of second substrate 2 is less than that of the central portion; and the thickness of base substrate 3 is less than that of the central portion.

In addition, in a wiring board according to the First Embodiment of the present invention, first substrate 1 and second substrate 2 have a layered structure having a rectangular outline. However, they are not limited to such, but may have a layered structure having a circular, hexagonal or octagonal outline.

Also, in the First Embodiment, first substrate 1 and second substrate 2 are made of epoxy resin. However, first substrate 1 and second substrate 2 are not limited to such, but may be made of polyimide, polycarbonate, polybutylene-telephtarate or polyacrylate. In addition, if first substrate 1 and second substrate 2 are made of epoxy resin, naphthalene-type epoxy resin, dicyclo-penta-diene-type epoxy resin, biphenyle-type epoxy resin or bisphenole-type epoxy resin may also be used.

In the First Embodiment, as for solder 9, Sn/Ag/Cu was used. However, solder 9 is not limited to such; solder containing antimony, tin, lead, indium or copper may be used. Also, eutectic crystal metals such as Sn/Sb, Sn/Ag, Sn/Pb or Sb/Cu may be used as well. Among such eutectic crystal metals, to avoid having a bad influence on the substrates, using those having relatively low melting temperatures, 250°C or lower, is preferred.

In addition, first substrate 1 is not necessarily formed single-layered, but may be formed multi-layered. Namely, first substrate 1 may be structured with a lower-layer insulation layer and an upper-layer insulation layer. Here, a lower-layer insulation layer indicates the insulation layer formed close to base substrate 3; and an upper-layer insulation layer indicates an insulation layer formed on the outer surface of the wiring board. Furthermore, first substrate 1 may be structured with a lower-layer insulation layer, an upper-layer insulation layer and an intermediate insulation layer positioned in between. The intermediate insulation layer may be made multi-layered. In the First Embodiment, the lower-layer insulation layer corresponds to epoxy-resin layer (1c), the intermediate insulation layer corresponds to epoxy-resin layer (1b) and the upper-layer insulation layer corresponds to epoxy-resin layer (1a).

Also, the second substrate is not necessarily formed single-layered, but may be formed multi-layered. Second substrate 2 may also be structured with a lower-layer insulation layer and an upper-layer insulation layer. Furthermore, second substrate 2 may be structured with a lower-layer insulation layer, an upper-layer insulation layer and an intermediate insulation layer positioned in between. In the First Embodiment, the lower-layer insulation layer corresponds to epoxy-resin layer (2a), the intermediate insulation layer corresponds to epoxy-resin layer (2b) and the upper-layer insulation layer corresponds to epoxy-resin layer (2c). On top of the upper-layer insulation layer and on top of the lower-layer insulation layer, conductive patterns may be formed. And, those conductive patterns may be connected with each other through vias 44.

### Industrial Applicability

The present invention may be practiced in a wiring board which can mount electronic components, specifically, in a wiring board which can mount electronic components for compact electronic devices.

## Claims

1. A wiring board (19) comprising:
a first substrate (1);
a second substrate (2) having a smaller mounting area than that of the first substrate (1); and
a base substrate (3) laminated between the first substrate (1) and the second substrate (2), wherein
at least a portion of the periphery is made thinner than the central portion,
vias (44) are formed at least either in the first substrate (1) or the second substrate (2), and
in the base substrate (3), the thickness of the portion bonded only to the first substrate (1) is less than the portion sandwiched between the first substrate (1) and the second substrate (2).

2. A wiring board (19) comprising:
a first substrate (1);
a second substrate (2) having a smaller mounting area than that of the first substrate (1); and
a base substrate (3) laminated between the first substrate (1) and the second substrate (2), wherein
at least a portion of the periphery is made thinner than the central portion,
vias (44) are formed at least either in the first substrate (1) or the second substrate (2), and
in the base substrate (3), portions bonded only to the first substrate (1) are formed intermittently.

3. The wiring board (19) according to Claim 1, wherein the base substrate (3) is formed with base material of resin-impregnated inorganic fabric, the first substrate (1) is formed with at least either resin containing inorganic filler or pliable resin, and the second substrate (2) is formed with at least either resin containing inorganic filler or pliable resin.

4. The wiring board (19) according to Claim 3, wherein the inorganic fabric contains glass cloth.

5. The wiring board (19) according to Claim 3, wherein the inorganic filler contains at least either silica filler or glass filler.

6. The wiring board (19) according to Claim 2, wherein the base substrate (3) is formed with base material of resin-impregnated inorganic fabric, the first substrate (1) is formed with at least either resin containing inorganic filler or pliable resin, and the second substrate (2) is formed with at least either resin containing inorganic filler or pliable resin.

7. The wiring board (19) according to Claim 6, wherein the inorganic fabric contains glass cloth.

8. The wiring board (19) according to Claim 6, wherein the inorganic filler contains at least either silica filler or glass filler.

9. The wiring board (19) according to Claim 1, wherein the base substrate (3) is formed with resin containing inorganic filler, and at least either the first substrate (1) or the second substrate (2) is formed with base material of resin-impregnated inorganic fabric.

10. The wiring board (19) according to Claim 9, wherein the inorganic fabric contains glass cloth.

11. The wiring board (19) according to Claim 9, wherein the inorganic filler contains at least either silica filler or glass filler.

12. The wiring board (19) according to Claim 2, wherein the base substrate (3) is formed with resin containing inorganic filler, and at least either the first substrate (1) or second substrate (2) is formed with base material of resin-impregnated inorganic fabric.

13. The wiring board (19) according to Claim 12, wherein the inorganic fabric contains glass cloth.

14. The wiring board (19) according to Claim 12, wherein the inorganic filler contains at least either silica filler or glass filler.

15. The wiring board (19) according to Claim 1, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

16. The wiring board (19) according to Claim 2, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

17. The wiring board (19) according to Claim 1, wherein on the inner surface of the via (44), a conductive layer is formed by plating, and the via (44) is filled with metal.

18. The wiring board (19) according to Claim 1, wherein on the inner surface of the via (44), a conductive layer is formed by plating, and the via (44) is filled with resin.

19. The wiring board (19) according to Claim 2, wherein on the inner surface of the via (44), a conductive layer is formed by plating, and the via (44) is filled with metal.

20. The wiring board (19) according to Claim 2, wherein on the inner surface of the via (44), a conductive layer is formed by plating, and the via (44) is filled with resin.

21. The wiring board (19) according to Claim 1, wherein the first substrate (1) is structured with a lower-layer insulation layer and an upper-layer insulation layer, and the second substrate (2) is structured with a lower-layer insulation layer and an upper-layer insulation layer.

22. The wiring board (19) according to Claim 21, wherein on the upper-layer insulation layer, a conductive pattern is formed; on lower-layer insulation layer, a conductive pattern is formed; and the conductive pattern on the upper-layer insulation layer and the conductive pattern on the lower-layer insulation layer are connected through vias (44).

23. The wiring board (19) according to Claim 2, wherein the first substrate (1) is structured with a lower-layer insulation layer and an upper-layer insulation layer, and the second substrate (2) is structured with a lower-layer insulation layer and an upper-layer insulation layer.

24. The wiring board (19) according to Claim 23, wherein on the upper-layer insulation layer, a conductive pattern is formed; on lower-layer insulation layer, a conductive pattern is formed; and the conductive pattern on the upper-layer insulation layer and the conductive pattern on the lower-layer insulation layer are connected through vias (44).

25. A method of manufacturing a wiring board comprising:
a base-substrate forming step to form a base substrate (3);
an insulation-layer forming step to form insulation layers on both surfaces of the base substrate (3);
a via forming step to form vias (44) in the insulation layers; and
a cutting step, by cutting the insulation layers, to form a first substrate (1) and a second substrate (2) having a smaller mounting area than that of the first substrate (1), while making at least a portion of the periphery thinner than the center portion, wherein
in the cutting step, the portion of the base substrate (3) bonded only to the first substrate (1) is cut to make the portion thinner than the portion sandwiched between the first substrate (1) and the second substrate (2).

26. A method of manufacturing a wiring board comprising:
a base-substrate forming step to form a base substrate (3);
an insulation-layer forming step to form insulation layers on both surfaces of the base substrate (3);
a via forming step to form vias (44) in the insulation layers; and
a cutting step, by cutting the insulation layer, to form a first substrate (1) and a second substrate (2) having a smaller mounting area than that of the first substrate (1), while making at least a portion of the periphery thinner than the center portion, wherein
in the cutting step, the portions of the base substrate (3) bonded only to the first substrate (1) are cut so as to be formed intermittently.

27. The method of manufacturing a wiring board according to Claim 25, wherein the base substrate (3) is formed with base material of resin-impregnated inorganic fabric, the first substrate (1) is formed with at least either resin containing inorganic filler or pliable resin, and the second substrate (2) is formed with at least either resin containing inorganic filler or pliable resin.

28. The method of manufacturing a wiring board according to Claim 27, wherein the inorganic fabric contains glass cloth.

29. The method of manufacturing a wiring board according to Claim 27, wherein the inorganic filler contains at least either silica filler or glass filler.

30. The method of manufacturing a wiring board according to Claim 26, wherein the base substrate (3) is formed with base material of resin-impregnated inorganic fabric, the first substrate (1) is formed with at least either resin containing inorganic filler or pliable resin, and the second substrate (2) is formed with at least either resin containing inorganic filler or pliable resin.

31. The method of manufacturing a wiring board according to Claim 30, wherein the inorganic fabric contains glass cloth.

32. The method of manufacturing a wiring board according to Claim 30, wherein the inorganic filler contains at least either silica filler or glass filler.

33. The method of manufacturing a wiring board according to Claim 25, wherein the base substrate (3) is formed with resin containing inorganic filler, and at least either the first substrate (1) or the second substrate (2) is formed with base material of resin-impregnated inorganic fabric.

34. The method of manufacturing a wiring board according to Claim 33, wherein the inorganic fabric contains glass cloth.

35. The method of manufacturing a wiring board according to Claim 33, wherein the inorganic filler contains at least either silica filler or glass filler.

36. The method of manufacturing a wiring board according to Claim 26, wherein the base substrate (3) is formed with resin containing inorganic filler, and at least either the first substrate (1) or second substrate (2) is formed with base material of resin-impregnated inorganic fabric.

37. The method of manufacturing a wiring board according to Claim 36, wherein the inorganic fabric contains glass cloth.

38. The method of manufacturing a wiring board according to Claim 36, wherein the inorganic filler contains at least either silica filler or glass filler.

39. The method of manufacturing a wiring board according to Claim 25, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

40. The method of manufacturing a wiring board according to Claim 26, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

41. The method of manufacturing a wiring board according to Claim 25, wherein on the inner surface of the via (44), a conductive layer is formed by plating, and the via (44) is filled with metal.

42. The method of manufacturing a wiring board according to Claim 25, wherein on the inner surface of the via (44), a conductive layer is formed by plating, and the via (44) is filled with resin.

43. The method of manufacturing a wiring board according to Claim 26, wherein on the inner surface of the via (44), a conductive layer is formed by plating, and the via (44) is filled with metal.

44. The method of manufacturing a wiring board according to Claim 26, wherein on the inner surface of the via (44), a conductive layer is formed by plating, and the via (44) is filled with resin.

45. The method of manufacturing a wiring board according to Claim 25, wherein the first substrate (1) is structured with a lower-layer insulation layer and an upper-layer insulation layer, and the second substrate (2) is structured with a lower-layer insulation layer and an upper-layer insulation layer.

46. The method of manufacturing a wiring board according to Claim 45, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias (44).

47. The method of manufacturing a wiring board according to Claim 26, wherein the first substrate (1) is structured with a lower-layer insulation layer and an upper-layer insulation layer; and the second substrate (2) is structured with a lower-layer insulation layer and an upper-layer insulation layer.

48. The method of manufacturing a wiring board according to Claim 47, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias (44).
